# EUROPEAN PATENT APPLICATION

(11) **EP 4 312 470 A1**
(43) Date of publication of application: **31.01.2024**
(21) Application number: 22187912.5
(22) Date of filing: 29.07.2022
(51) Int. Cl.: H05K 1/02, H05K 1/11, H05K 1/18

(54) **COMPONENT CARRIER WITH SIGNAL CONDUCTIVE ELEMENT AND SHIELDING CONDUCTIVE STRUCTURE**

(71) Applicant: AT & S Austria Technologie & Systemtechnik Aktiengesellschaft, 8700 Leoben-Hinterberg (AT)
(72) Inventor: Schober, Mario, 8793 Trofaiach (AT); Stahr, Johannes, 8605 St. Lorenzen im Mürztal (AT)
(74) Representative: Dilg, Haeusler, Schindelmann Patentanwaltsgesellschaft mbH

(57) **Abstract**

A carrier assembly 100 is provided, which comprises (i) a component carrier 101; (ii) a component 110 in or on the component carrier 101; (iii) a signal conductive element 120 provided on a component surface 111 of said component 110; and (iv) a shielding conductive structure 130, which is at least partially embedded in the component carrier 101 and which at least partially surrounds said signal conductive element 120.

## Description

### Technical Field

The present invention generally relates to the technical field of component carriers as mechanical support structures for electronic components and for electrically contacting electronic components. Specifically, the present invention relates to carrier assemblies comprising a component carrier and a component with signal transmission and/or signal processing capabilities.

### Background

The designs of printed circuit boards (PCBs) and of components mounted on or embedded in printed circuit boards are increasingly becoming smaller and better adapted for faster signal transmission and processing. Especially for high-frequency signals in the GHz range, controlled impedances of traces play a crucial role for signal integrity and thus for overall performance of printed circuit boards. This is of particular importance in fields such as telecommunication, e.g. for 5G and 6G applications, or analog video processing.

For example, having an embedded radio frequency (RF) chip inside a printed circuit board requires an impedance controlled line connecting the chip. The radio frequency output of the chip, which is connected to an impedance controlled line, is radiating. This may lead to unwanted coupling of the output to the RF chip and/or the input of the chip and vice versa. Such coupling often causes instability of the radio frequency chip.

Thus, there may be a need for carrier assemblies comprising signal processing components providing improved signal quality.

### Summary of the Invention

This need may be met by the subject matter according to the independent claims. Advantageous embodiments of the present invention are described by the dependent claims.

According to an aspect of the invention, a carrier assembly is provided. The carrier assembly comprises (i) a component carrier, (ii) a component, in particular an RF component, in or on the component carrier, (iii) a signal conductive element provided on a component surface, preferably a main surface, of said component; and (iv) a shielding conductive structure, which is at least partially embedded in the component carrier and which at least partially surrounds or encircles said signal conductive element.

In the context of the present application, the term "carrier assembly" may particularly denote any structure or arrangement comprising a component carrier and a component. The component may be mounted on and/or embedded in the component carrier. The carrier assembly may comprise more than one component and/or more than one component carrier.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers. The component carrier may include one or more components mounted on or embedded in the component carrier.

The component carrier may comprise a "stack" of at least one electrically insulating layer structure and/or at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

The term "layer structure" may denote a continuous layer, a patterned layer or a plurality of non-consecutive islands within a common plane. The different layer structures are stacked on top of each other in a "stacking direction". The stacking direction of the component carrier or stack is parallel to the surface normal of the main surfaces of the layer structures and/or the main surfaces of the stack. A "main surface" of a layer, layer structure or stack may be either one of those two surfaces, which have the largest extension compared with the other surfaces. The main surface may be defined as a surface perpendicular to the stacking direction. A "side surface" of a layer, layer structure or stack may be any external surface, which is not a main surface. A side surface may be any external surface which is perpendicular to a main surface and/or which extends along the stacking direction. A "vertical direction" may be defined with respect to a given stack as being parallel to the stacking direction. A "horizontal direction" may be defined with respect to a given stack as any direction perpendicular to the stacking direction.

A "component" may be an electronic component, which may be any physical entity forming part of an electronic system. An electronic component may have one or more electrical terminals or leads, configured for electrically contacting the electronic component. It may comprise one or more electronic circuits which may be configured to implement a particular function or subfunction of the component, in particular in the context of the electronic system. A component may itself comprise one or more subcomponents being themselves components. It may comprise a carrier for mechanical stabilization of the component, as a support structure for different parts of the component and/or for electrically connecting different parts of the component. A component may comprise a housing and/or encapsulation protecting the component from external influences, e.g. mechanical or electromagnetic influences. A component may be an active, passive or electromechanical component.

The component may be surface mounted to the stack, e.g. at a top or bottom surface of the stack with respect to the stacking direction or at a side surface of the stack with respect to the stacking direction. The component may be at least partly, in particular fully, embedded in the component carrier. It may be arranged in a recess or a cavity of the component carrier. When embedded, the entire surface of the component may be in contact with the stack, or at least parts of the surface of the component may not be in contact with the stack. The component may be separated from the stack by a gap which may be defined by the cavity or recess, in which the component is arranged.

In the context of the present application, the term "RF component" may particularly denote any component that is configured to receive, send and/or process radio frequency (RF) signals. Alternatively, high frequency (HF) signals may be received, sent, and/or processed. Radio frequency may refer to the rate of oscillation of electromagnetic radio waves in the range of approximately 3 kHz to 300 GHz, as well as the alternating currents carrying such radio signals. An RF component may be configured to receive radio signals, transform radio signals, analyze radio signals, and/or send radio signals, in particular of frequencies greater than 100 MHz, in particular greater than 1 GHz.

In the context of the present application, the term "signal conductive element" may particularly denote any object or structure capable of transmitting a signal from one location to another different location. Signals may be transmitted through the signal conductive element by means of a carrier such as an electric current and/or electromagnetic waves. The electric current may be a DC current and/or AC current. The signal conductive elements may but need not be electrically conductive. It may for example comprise or consist of copper. Alternatively, the signal conductive elements may comprise dielectric material. The signal conductive element may form part of the component and/or the component carrier. It may also be separately formed. The signal conductive element may form part of an antenna and/or may constitute an antenna. The shape of the signal conductive element is not limited to any specific shape. In one example the shape of the signal conductive element may comprise edges e.g. triangle or rectangle. In a different example the signal conductive element may comprise round shapes e.g. circle. The signal conductive element may be configured to be connected with an impedance controlled line. The carrier assembly may comprise one, two, three, four, five, more than five, more than ten, or even more than a hundred signal conductive elements.

In the context of the present application, the term "shielding conductive structure" may particularly denote a structure arranged to shield one part or region of the carrier assembly from another part or region of the carrier assembly. For example, the shielding conductive structure may be arranged to shield different parts of the carrier assembly from interfering influences or disturbances originating in other parts, e.g. from electromagnetic interferences. The shielding structure may shield an RF signal input port from an RF signal output port and/or vice versa. The shielding conductive structure may comprise a plurality of shielding conductive elements, which are separately formed. It may but need not be electrically conductive. It may for example comprise or consist of copper. At least part, in particular, all of the shielding conductive structure may be connected to a reference potential, in particular be grounded. The shielding conductive structure may be connected directly to a ground structure of the component, in particular to guarantee a complete shielded path from the component through the component carrier to the outside of the component carrier. The shielding conductive structure may form part of the component and/or the component carrier. It may also be separately formed.

The shielding conductive structure may be arranged symmetrically around the signal conductive element, for example point-symmetrically and/or mirrorsymmetrically with respect to one or more symmetry axes. The distance between the signal conductive element and the shielding conductive structure may vary, in particular by at most 25 percent, in particular by at most 10 percent, or it may remain constant. Furthermore, the shielding conductive structure may comprise electrically conductive material, in particular copper.

The signal conductive element may have an "extension direction", along which signals may be conducted. It may be in direct and/or indirect contact with the component, in particular with the component surface on which the signal conductive element is provided. The extension direction may, but need not be orthogonal to this surface. The shielding conductive structure may also extend along the extension direction, for example by having approximately the same cross section along the extension direction. The shielding conductive structure may be provided on the same surface as the signal conductive element. The shielding conductive structure may be in direct and/or indirect contact with the component, in particular with the component surface on which the shielding conductive structure is provided. The signal conductive element and/or the shielding conductive structure may be connected to respective electrical contacts of the component.

The "component surface", on which the signal conductive element and/or shielding conductive structure is provided, may be any outer surface of the component. It may be any surface of the component in direct contact with the component carrier. It may be a main surface of the component or a side surface of the component. Additionally and/or alternatively, the component surface may comprise at least one protruding (electrically conductive) connection element, in particular a pillar, which may be configured to connect the component with the signal conductive element. Different signal conductive elements may be provided on different surfaces of the component.

The expression that the shielding conductive structure is "at least partially embedded" in the component carrier may particularly denote that at least part of the shielding conductive structure is in direct contact with an inner part of the component carrier, i.e. is in direct contact not only with an outer surface of the component carrier. The expression may denote that at least part of the shielding conductive structure is in direct contact with an inner layer structure of the component carrier, i.e. a layer structure which does not form an outer layer structure in stacking direction. The shielding conductive structure may be fully embedded. For example, it may be fully surrounded by the carrier assembly. All of the outer surface of the shielding conductive structure may be in direct contact with the carrier assembly.

The expression that the shielding conductive structure "at least partially surrounds" the signal conductive element may particularly denote that the shielding conductive structure at least partially surrounds the signal conductive element in a plane perpendicular to the extension direction. It may at least partially surround the signal conductive element at all such planes along the extension direction. Viewed from the signal conductive element, the shielding structure may cover at least an angle of 10 degrees, in particular of 25 degrees, in particular of 90 degrees, in particular of 180 degrees. Individual gaps in the shielding structure may cover less than 120 degrees, in particular less than 90 degrees, in particular less than 60 degrees. The angles may be defined in terms of a plane, which is perpendicular to the extension direction. The shielding conductive structure may cover the sightline between the signal conductive element and a part or region of the component carrier that is to be shielded from the signal conductive element or vice versa.

An advantage of the above-described carrier assembly may be that the signal conductive element is at least partially shielded off so that interfering influences or disturbances, in particular due to electromagnetic radiation, coming from the signal conductive element are reduced or even fully eliminated. Conversely, the signal conductive element may itself be shielded from interfering influences or disturbances coming from other parts of the carrier assembly. The shielding conductive structure may for example shield particularly sensitive parts of the component and/or component carrier, for example signal conductive parts carrying signals with frequencies greater than 100 MHz or greater than 1 GHz. This may allow placing sensitive parts of the component and/or carrier, e.g. RF signal conductive elements such as RF ports and/or RF conductors, closer together resulting in more efficient and more flexible design options for carrier assemblies. For example, with a dedicated shielding structure on the chip, radiation may be reduced or even eliminated from an output of the chip and/or to an input of the chip. Furthermore, the shielding structure may be applied to the input of the chip and may improve the signal to noise ratio of the input signal. Thus, the overall signal quality of the carrier assembly may be improved.

The above-described carrier assembly may provide excellent impedance control of the signal input and output of the die using a coaxial structure. Effective shielding by a coaxial structure may be combined with impedance controlled lines to shield input and output of an RF-semiconductor. An advantage may further be an excellent shielding of an input and/or output of an RF semiconductor chip to avoid radiation. The product may be particularly useful for applications in the GHz range, which need impedance controlled lines.

According to an embodiment of the invention, the component comprises a first and a second main surface, one of which is the component surface on which the signal conductive element is provided.

According to a further embodiment of the invention, said shielding conductive structure comprises at least one shielding conductive element, in particular a plurality of shielding conductive elements, surrounding said signal conductive element. At least one of said shielding conductive elements may be connected to the component surface, in particular to one of a first or a second main surface of said component. It may be connected directly or indirectly, i.e. through an intermediate material such as solder, in particular solder paste, or sinter paste. The at least one of said shielding conductive elements may be electrically connected to the component surface, in particular to an electrical contact on the component surface. All shielding conductive elements may be formed spatially separate from each other or at least two, in particular all, of the shielding conductive elements may be connected.

The plurality of shielding conductive elements may comprise two, three, four, five, more than five, more than ten or even more than a hundred shielding conductive elements. The shielding conductive elements may be arranged in a circle around the signal conductive element. They may all be arranged at a similar distance from the signal conductive element, in particular at the same distance. The distance may deviate by less than fifty percent, in particular less than ten percent, in particular less than five percent. Alternatively or in addition, the shielding conductive elements may be arranged so that neighbouring elements have a similar distance from each other, in particular the same distance. Some or all of the shielding conductive elements may be formed as walls and/or some or all of the shielding conductive elements may have a circular cross section, in particular in a plane parallel to the component surface. An extension direction of at least one of the shielding conductive elements, in particular all shielding conductive elements, may be perpendicular to the component surface.

The above embodiment may be advantageous because a plurality of shielding conductive elements may be more easily manufactured with standard techniques, e.g. standard techniques for via formation, as opposed to a single contiguous shielding conductive structure. At the same time, the plurality of shielding conductive elements may shield as well or almost as well as a single contiguous shielding conductive structure.

According to a further embodiment of the invention, said shielding conductive structure comprises a shielding conductive wall at least partially surrounding or encircling said signal conductive element. The shielding conductive wall may correspond to a shielding conductive element. The shielding conductive wall, in particular its height, may extend along the stacking direction of the component carrier and/or a component carrier thickness direction. It may be arranged perpendicularly to the component surface. It may be a transversal and/or vertical wall. The shielding conductive wall may be curved, in particular form part of a circle or an oval, or it may be straight. The wall may be solid without any holes or it may have one or more holes, e.g. forming a grid. The shielding conductive wall may be electrically conductive. It may comprise or consist of copper. The shielding conductive structure may comprise a plurality of shielding conductive walls.

The above-described shielding conductive wall may be advantageous because it may provide a particularly good shielding, e.g. compared to shielding conductive elements which are arranged separately from each other with gaps between the elements. The shielding conductive wall may electrically connect different shielding conductive elements facilitating the grounding of the whole shielding conductive structure.

According to a further embodiment of the invention, the shielding conductive wall is connected to at least one other shielding conductive element, in particular one or more shielding conductive elements with circular cross-sections.

According to a further embodiment of the invention, said shielding conductive structure entirely surrounds said signal conductive element, in particular encircles said signal conductive element.

The expression "entirely surrounds" may particularly denote that the shielding conductive structure entirely surrounds the signal conductive element at one point along the extension of the signal conductive element, in particular along the full extension of the signal conductive element. There may be gaps, in particular gaps of less than 120 degrees, in particular of less than 90 degrees, in particular of less than 60 degrees, in particular of less than 30 degrees, in particular of less than 10 degrees. The angles may be defined in a plane parallel to the component surface and/or orthogonal to the extension direction. Alternatively, there may be no gaps.

The above embodiment may be advantageous as the shielding structure may shield the signal conductive element in all directions, in particular in all directions perpendicular to the direction of signal propagation along the signal conductive element.

According to a further embodiment of the invention, a vertical extension or height of the signal conductive element is greater than a vertical extension or height of the shielding conductive structure. Alternatively, it may be smaller. It may also be equal.

According to a further embodiment of the invention, at least part of the shielding conductive structure is connected to a reference potential, in particular is grounded. One of the shielding conductive elements may be connected to the reference potential. All of the shielding structure, in particular all shielding conductive elements, may be connected to the reference potential.

Such an embodiment may be advantageous to effectively shield electromagnetic influences of the signal conductive structure comparable for example with a coaxial cable.

According to a further embodiment of the invention, said component carrier comprises a stack comprising at least one electrically conductive layer structure and at least one electrically insulating layer structure.

According to a further embodiment of the invention, said signal conductive element comprises a conductive interconnection, said conductive interconnection being connected to the component surface, in particular an electrical contact on the component surface, and to an electrically conductive layer structure of the component carrier, in particular to an antenna pad at least partially formed by part of the electrically conductive layer structure. The electrically conductive layer structure may form part of the stack of the component carrier. The conductive interconnection may be electrically conductive and/or may be signal conductive, i.e. capable of transmitting a signal such as an electromagnetic wave. The antenna pad may be configured to send and/or receive a signal, which is transmitted through the signal conductive element.

According to a further embodiment of the invention, said signal conductive element and/or said shielding conductive structure, in particular at least one of the shielding conductive elements, e.g. all of them, comprise a plurality of stacked elements being stacked on top of each other, each stacked element comprising at least one of a via, a plated through hole, a pillar, and a nanowire. Individual stacked elements may each connect neighbouring electrically conductive layer structures. The stacked elements may be vertically stacked. At least two subsequent stacked elements may be offset with respect to each other or none of the stacked elements may be offset with respect to each other. In an example the plurality of stacked elements may comprise a cylindrical shape. In a further example, the plurality of stacked elements may comprise a frustoconical shape.

The above embodiment may be advantageous, because conventional techniques used in the production of component carriers may be used to form the signal conductive element and/or the shielding conductive structure, for example conventional techniques for via formation or pillar formation. This may be particularly effective and cost-efficient.

According to a further embodiment of the invention, at least part of the shielding conductive structure is configured as a dome, which at least partially covers said signal conductive element. The dome may extend from the component surface. To form the dome, the shielding conductive structure may connect to an electrically conductive layer structure of the layer stack so that a part of the electrically conductive layer structure extends over an inner region surrounded by the shielding conductive structure. The inner region may be completely covered by the electrically conductive layer structure or there may be at least one hole, in particular above the signal conductive element. The signal conductive element may not reach up to the top of the dome, i.e. may terminate below the top of the dome.

The above embodiment may be advantageous to shape a signal emitted and/or received by the signal conductive element, in particular to focus the direction, in which the signal is emitted and/or received. The dome may function as a slit resonator. The embodiment may further reduce interferences of the signal conductive element with other parts of the carrier assembly.

According to a further embodiment of the invention, at least part of the shielding conductive structure is configured as a funnel, in particular extending up to a carrier surface of the component carrier. The funnel may be formed by a plurality of stacked elements, which are horizontally offset with respect to each other. The carrier surface may be an outer surface of the component carrier. The carrier surface may be above the component surface and/or may be parallel to the component surface.

The above embodiment may be advantageous to shape a signal emitted and/or received by the signal conductive element, for example to increase the intensity and/or focus of a signal emitted and/or received.

According to a further embodiment, the dome and/or the funnel are configured as a heat distribution structure, in particular to lead or dissipate heat to a surface of the component carrier.

According to a further embodiment of the invention, the shielding conductive structure, in particular the at least one shielding conductive element and/or the shielding conductive wall, is connected to an electrically conductive layer structure of the component carrier in a position that said signal conductive element is provided, in particular provided exclusively, between the component main surface and said electrically conductive layer structure along the stacking direction and/or the stack thickness direction.

Such an embodiment may be advantageous, because the shielding conductive structure in combination with the electrically conductive layer structure may form a resonator, in particular a slit resonator. Furthermore, the embodiment may be an efficient way to form a dome-like structure over the signal conductive element as previously described.

According to a further embodiment of the invention, the carrier assembly comprises at least one of the following features: (i) the component is at least partially covered by an outer conductive shield, in particular on a surface of the component opposite to the component surface on which said signal conductive element is provided and/or on respective lateral surfaces of the component; and (ii) the component comprises an internal conductive shield covering within the component a portion of the component surface, where said signal conductive element is provided. The lateral surfaces may refer to surfaces which extend along the stacking direction of the component carrier and/or surfaces which are orthogonal to the component surface and/or the surface opposite to the component surface. The internal conductive shield may be embedded in the component, in particular fully embedded. The shielding conductive structure may comprise the outer conductive shield and/or the internal conductive shield.

The outer conductive shield and/or the internal conductive shield may further shield the signal conductive element in directions, in which the (other parts of the) shielding conductive structure may not effectively shield the signal conductive element.

According to a further embodiment of the invention, an additional component, preferably a power amplifier, is provided on the component surface, where said signal conductive element is provided, the additional component comprising an additional shielding conductive structure at least partially surrounding and/or covering said additional component. The additional shielding conductive structure may completely surround and/or cover the additional component. A space defined by the additional shielding conductive structure, in particular between the additional component and the additional shielding conductive structure, may contain air and/or dielectric material.

Additional components such as power amplifiers may be required to transform the signal so that it can be processed by the component. These additional components may be a source of interferences and/or may themselves be susceptible to interferences. Therefore, an additional shielding conductive structure for these additional components may increase the flexibility of positioning them on the main surface.

According to a further embodiment of the invention, two signal conductive elements are connected on the component surface, said at least one additional component being provided between said two signal conductive elements, and said additional shielding conductive structure being configured to at least partially shield said additional component from said two signal conductive elements. The two signal conductive elements may correspond to an input port and an output port, respectively. The additional component may comprise at least two connections, each connecting the additional component to a respective signal conductive element. The connections to the two signal conductive elements may be established via an input port and an output port, respectively. More than one additional component each with an additional shielding conductive structure may be positioned between the two signal conductive elements, in particular two power amplifiers. Such an embodiment may be advantageous to further shield the two signal conductive elements from each other, while at the same time shielding additional components of the carrier assembly.

According to a further embodiment of the invention, said signal conductive element comprises a conductive vertical structure connected to a conductive surface portion of the component, in particular to an electrical contact of the component, provided on the component surface. The conductive surface portion may be electrically conductive. The conductive vertical structure may be directly connected or indirectly connected, i.e. through an intermediate material such as solder, in particular solder paste.

According to a further embodiment of the invention, said shielding conductive structure is connected to the component surface. It may be directly connected or indirectly connected, i.e. through an intermediate material such as solder, in particular solder paste, or sinter paste.

According to a further embodiment of the invention, said signal conductive element is configured as at least one of a blind via, a through via, a plated through hole, a pillar, an interconnection between component carriers, a nanowire, a sputtered material, a solder material, and an electrically conductive adhesive.

According to a further embodiment of the invention, said component is embedded in a stack of the component carrier.

According to a further embodiment of the invention, said signal conductive element extends away from the component surface along an extension direction, said shielding conductive structure being configured and positioned to at least partially extend along said extension direction.

According to a further embodiment of the invention, said shielding conductive structure surrounds or covers said signal conductive element along the stacking direction and/or the stack thickness direction.

According to a further embodiment of the invention, the shielding conductive structure comprises an electrically conductive cylinder, in particular a vertical copper cylinder. The electrically conductive cylinder may be covered by an electrically conductive plane, in particular a copper plane. The electrically conductive plane may have an opening, which may be configured to connect an impedance control line with the signal conductive element. The signal conductive element may comprise a pillar, in particular a copper pillar. The pillar may be arranged in the center of the electrically conductive cylinder. The pillar may provide a contact, in particular for an impedance control line.

According to a further embodiment of the invention, the shielding conductive structure and the signal conductive element form a vertical coaxial structure.

In the following further considerations are presented which may be relevant at least for some embodiments of the invention:
In an embodiment, the stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, socalled prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, and magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (AI203) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga203), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element.

However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

Some embodiments have been described with reference to apparatus type claims whereas other embodiments have been described with reference to method type claims. However, a person skilled in the art will gather from the above and the following description that, unless otherwise indicated, any combination of features relating to method type claims with features relating to apparatus type claims is disclosed with this document, both with respect to the apparatus as well as with respect to the method.

The aspects defined above and further aspects of the present invention are apparent from the examples of embodiment to be described hereinafter and are explained with reference to the examples of embodiment.

### Brief Description of the Drawings

Figure 1 shows a carrier assembly including a signal conductive element and a shielding conductive structure according to an exemplary embodiment of the invention.
Figure 2 shows a top view and a cross-sectional side view of a signal conductive element and a shielding conductive structure according to an exemplary embodiment of the invention.
Figure 3 shows a top view of a signal conductive element surrounded by shielding conductive elements according to an exemplary embodiment of the invention.
Figure 4 shows a cross-sectional side view of a component comprising an outer conductive shield and an internal conductive shield according to an exemplary embodiment of the invention.
Figure 5 shows a component surface on which two signal conductive elements with respective shielding conductive structures as well as two power amplifiers are arranged according to an exemplary embodiment of the invention.

### Detailed Description

The illustrations in the drawings are schematic. In different drawings, similar or identical elements are provided with the same reference signs. For the sake of clarity and comprehensibility, reference signs are sometimes omitted for those features, for which reference signs have already been provided in earlier figures.

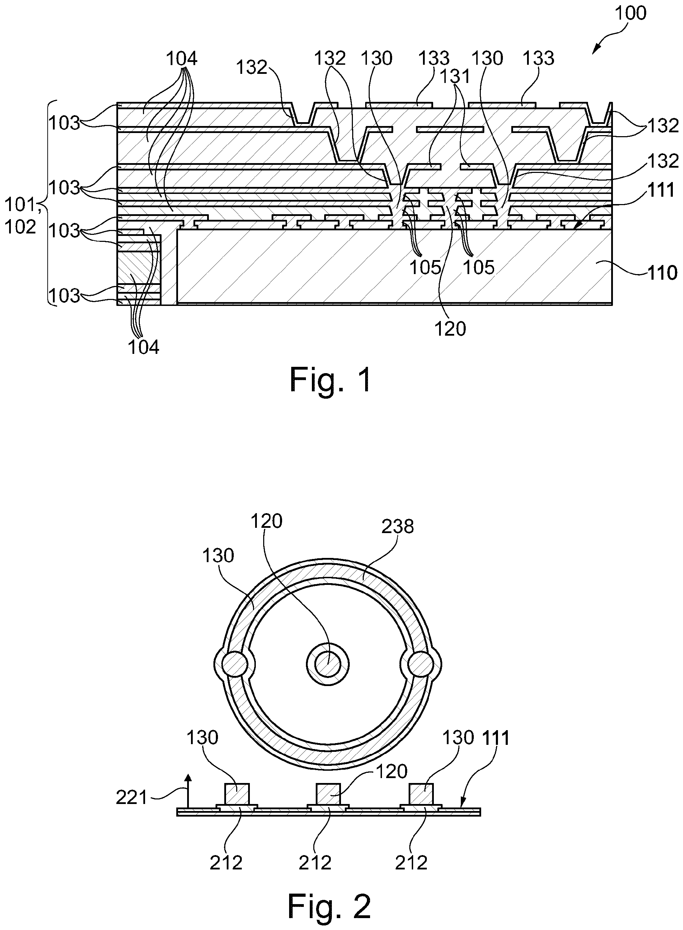

**Figure 1** shows high frequency (HF) path shielding on PCB level. It shows a carrier assembly 100. The carrier assembly 100 comprises (i) a component carrier 101, (ii) a component 110 embedded in the component carrier 101, (iii) a signal conductive element 120 provided on a component surface 111 of said component 110; and (iv) a shielding conductive structure 130, which is at least partially embedded in the component carrier 101 and which at least partially surrounds said signal conductive element 120.

The component carrier 101 includes a stack 102 comprising a plurality of electrically conductive layers 103 and a plurality of electrically insulating layers 104. Further electrically conductive layers and electrically insulating layers could be added below so that the component 110 is fully embedded. The signal conductive element 120 and the shielding conductive structure 130 are each formed in terms of stacked vias 105 (without horizontal shifting in the lower layer structures). The signal conductive element 120 and the shielding conductive structure 130 are both connected to a surface 111 of the component carrier 101. At the respective connection points, electrical contacts are positioned for contacting the component 110. The signal conductive element 120 does not reach an outer surface of the component carrier 101 but ends at an inner electrically conductive layer 103 of the plurality of electrically conductive layers 103. The shielding conductive structure 130 forms a dome 131 above the signal conductive element 120 with the covering part of the dome 131 formed by an inner electrically conductive layer structure 103. The covering part of the dome 131 has an opening above the signal conductive structure 120. Further parts of the shielding conductive structure 130 form a funnel 132 extending up to an outer surface of the component carrier 101, which is opposite and parallel to the component surface 111. Dome 131 and funnel 132 are at least partially formed by stacked plated through-holes and/or vias. At least one portion of the surface area of the component carrier 101 may comprise a surface finish e.g. ENIPIG or solder resist (not shown in this figure).

**Figure 2** shows a shielding wall structure on chip level. It shows in the upper part a top view and in the lower part a cross-sectional side view of a signal conductive element 120 and a shielding conductive structure 130. The shielding conductive structure 130 comprises a solid shielding wall 238 fully encircling the signal conductive element 120. The shielding conductive structure 130 and the signal conductive element 120 both extend along an extension direction 221 which is perpendicular to the component surface 111, on which the signal conductive element 120 and the shielding conductive structure 130 are arranged. Both the signal conductive element 120 and the shielding conductive structure 130 are connected with electrical contacts 212 of the component 110.

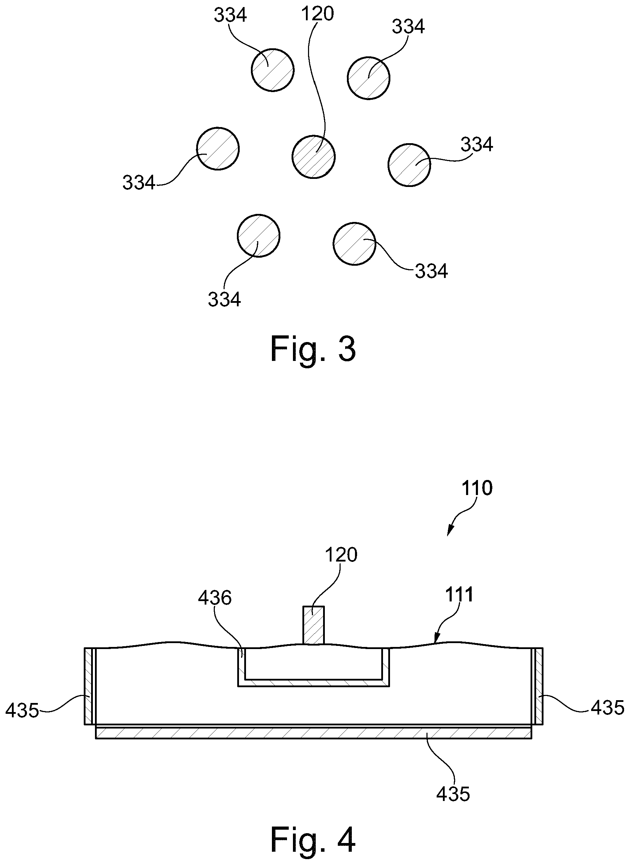

**Figure 3** shows a top view of a signal conductive element 120 surrounded by a shielding conductive structure 130 which is formed of a plurality of shielding conductive elements 334. The shielding conductive elements 334 are all positioned at the same distance from the signal conductive element 120. Also, neighboring conductive elements 334 all have the same distance from each other.

**Figure 4** shows a cross-sectional side view of a component 110 with a signal conductive element 120 connected to a component surface 111 of the component 110. The component 110 comprises an outer conductive shield 435 covering all surfaces of the component 110 other than the surface 111 on which the signal conductive element 120 is arranged. Furthermore, the component 110 comprises an internal conductive shield 436 covering a surface portion of component surface 111, on which surface portion the signal conductive element 120 is arranged.

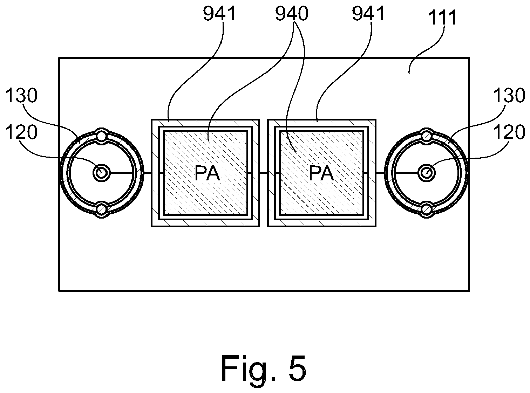

**Figure 5** shows an area shielding structure on chip level. It shows a component surface 111 on which two signal conductive elements 120 with respective shielding conductive structures 130 as well as two additional components 940, here power amplifiers (PA), are arranged. The additional components 940 are each surrounded by a respective additional shielding conductive structure 941. The additional components 940 are arranged between the two signal conductive elements 120 providing additional shielding of the signal conductive elements 120 from each other. Each of the signal conductive elements 120 is connected to a respective additional component 940 and the additional components 940 are connected with each other.

It should be noted that the term "comprising" does not exclude other elements or steps and the use of articles "a" or "an" does not exclude a plurality. Also, elements described in association with different embodiments may be combined. It should also be noted that reference signs in the claims should not be construed as limiting the scope of the claims.

### List of reference signs:

- 100: carrier assembly
- 101: component carrier
- 102: stack
- 103: electrically conductive layer structure
- 104: electrically insulating layer structure
- 105: via
- 110: component
- 111: component surface
- 120: signal conductive element
- 130: shielding conductive structure
- 131: dome
- 132: funnel
- 133: antenna pad
- 212: electrical contact
- 221: extension direction
- 238: shielding conductive wall
- 334: shielding conductive element
- 435: outer conductive shield
- 436: internal conductive shield
- 940: additional component
- 941: additional shielding conductive structure

## Claims

1. A carrier assembly (100), wherein the carrier assembly (100) comprises:
a component carrier (101);
a component (110) in or on the component carrier (101);
a signal conductive element (120) provided on a component surface (111) of said component (110); and
a shielding conductive structure (130), which is at least partially embedded in the component carrier (101) and which at least partially surrounds said signal conductive element (120).

2. The carrier assembly (100) according to claim 1, wherein said shielding conductive structure (130) comprises a plurality of shielding conductive elements (334) surrounding said signal conductive element (120).

3. The carrier assembly (100) according to any of claims 1 to 2, wherein said shielding conductive structure (130) comprises a shielding conductive wall (238) at least partially surrounding said signal conductive element (120).

4. The carrier assembly (100) according to any of claims 1 to 3, wherein said shielding conductive structure (130) entirely surrounds said signal conductive element (120).

5. The carrier assembly (100) according to any of claims 1 to 4, wherein at least part of said shielding conductive structure (130) is connected to a reference potential, in particular is grounded.

6. The carrier assembly (100) according to any of claims 1 to 5, wherein said signal conductive element (120) comprises a conductive interconnection, said conductive interconnection being connected to the component surface (111) and to an electrically conductive layer structure (103) of the component carrier (101), in particular to an antenna pad (133) formed by part of the electrically conductive layer structure (103).

7. The carrier assembly (100) according to any of claims 1 to 6, wherein said signal conductive element (120) and/or said shielding conductive structure (130) comprise a plurality of stacked elements (105) being stacked on top of each other, each stacked element (105) comprising at least one of a via, a plated through hole, a pillar, and a nanowire.

8. The carrier assembly (100) according to any of claims 1 to 7, wherein at least part of the shielding conductive structure (130) is configured as a dome (131), which at least partially covers said signal conductive element (120).

9. The carrier assembly (100) according to any of claims 1 to 8, wherein the shielding conductive structure (130) is connected to an electrically conductive layer structure (131) of the component carrier (101) in a position that said signal conductive element (120) is provided, in particular provided exclusively, between the component surface (111) and said electrically conductive layer structure (131) along the stack thickness direction.

10. The carrier assembly (100) according to any of claims 1 to 9, wherein the component (110) is at least partially covered by an outer conductive shield (435), in particular on a surface of the component (110) opposite to the component surface (111) on which said signal conductive element (120) is provided and/or on respective lateral surfaces of the component (110).

11. The carrier assembly (100) according to any of claims 1 to 10, wherein the component (110) comprises an internal conductive shield (436) covering within the component (110) a portion of the component surface (111), where said signal conductive element (120) is provided.

12. The carrier assembly (100) according to any of claims 1 to 11, wherein an additional component (940), preferably a power amplifier, is provided on the component surface (111) where said signal conductive element (120) is provided, the additional component (940) comprising an additional shielding conductive structure (941) at least partially surrounding and/or covering said additional component (940).

13. The carrier assembly (100) according to claim 12, wherein two signal conductive elements (120) are connected on the component surface (111), said at least one additional component (940) being provided between said two signal conductive elements (120), and said additional shielding conductive structure (941) being configured to at least partially shield said additional component (940) from said two signal conductive elements (120).

14. The carrier assembly (100) according to any of claims 1 to 13, wherein said signal conductive element (120) comprises a conductive vertical structure connected to a conductive surface portion (212) of the component (110), in particular to an electrical contact (212) of the component (110), provided on the component surface (111).

15. The carrier assembly (100) according to any of claims 1 to 14, wherein said shielding conductive structure (130) is connected to the component surface (111).

16. The carrier assembly (100) according to any of claims 1 to 15, wherein said shielding conductive structure (130) surrounds or covers said signal conductive element (120) along the stack thickness direction.
